# EUROPÄISCHE PATENTSCHRIFT

(11) **EP 0 362 275 B1**
(45) Veröffentlichungstag und Bekanntmachung des Hinweises auf die Patenterteilung: **22.12.1993**
(21) Anmeldenummer: 88905202.3
(22) Anmeldetag: 14.06.1988
(51) Int. Cl.: H01L 29/16, C23C 16/26, H01L 21/365

(54) **HERSTELLUNG EINES HALBLEITERGRUNDMATERIALS**
FABRICATION OF A SEMICONDUCTOR BASE MATERIAL
FABRICATION D'UN MATERIAU DE BASE POUR SEMICONDUCTEURS

(30) Priorität: 03.08.1987 DE 3725700
(43) Veröffentlichungstag der Anmeldung: 11.04.1990
(73) Patentinhaber: SIEMENS AKTIENGESELLSCHAFT, 80333 München (DE)
(72) Erfinder: BIRKLE, Siegfried, D-8552 Höchstadt (DE); KAMMERMAIER, Johann, D-8025 Unterhaching (DE); SCHULTE, Rolf, D-8520 Erlangen (DE); WINNACKER, Albrecht, D-8520 Erlangen (DE); RITTMAYER, Gerhard, D-8520 Erlangen (DE)
(86) Internationale Anmeldenummer: EP8800526
(87) Internationale Veröffentlichungsnummer: WO8901237

(56) Entgegenhaltungen:
- THIN SOLID FILMS, Band 136, Nr. 2, Februar 1986, Elsevier Sequoia, (Lausanne, CH), Z. HAS et al.: "Electrical properties of thin carbon films obtained by R.F. methane decomposition on an R.F.-powered negatively self-biased electrode", Seiten 161-166
- PHILOSOPHICAL MAGAZINE B, Band 46, Nr. 5, 1982, Taylor & Francis Ltd, (London, GB), D.I. Jones et al.: "Properties of hydrogenated amorphous carbon films and the effects of doping", Seiten 423-434
- PATENT ABSTRACTS OF JAPAN, Band 8, Nr. 114 (C-225)(1551), 26. Mai 1984 & JP-A-5926906
- PATENT ABSTRACTS OF JAPAN, Band 7, Nr. 132 (E-180)(1277), 9. Juni 1983 & JP-A-5848428

## Beschreibung

Die Erfindung betrifft ein Verfahren zur Herstellung eines neuen Halbleitergrundmaterials mit hohem Halbleitereigenschaftspotential aus Dünnschichten aus amorphem, wasserstoffhaltigem Kohlenstoff (a-C:H).

Als Halbleitergrundmaterialien sind insbesondere einkristallines Silicium (Si) und Galliumarsenid (GaAs) mit sehr hohen n- und p-Ladungsträgerbeweglichkeiten bekannt (» 1 cm².V⁻¹.s⁻¹). Nachteilig ist bei diesen Materialien, daß sie nicht als Dünnschichten nach einer Bandtechnologie mit flexiblen Trägern hergestellt werden können und daß zu ihrer Herstellung und Verarbeitung Hochtemperaturprozesse erforderlich sind.

Als Halbleitergrundmaterial ist ferner amorphes, wasserstoffhaltiges Silicium (a-Si:H) bekannt. Dieses Material ist zwar auf Dünnschichtbasis herstellbar, seine n- und p-Ladungsträgerbeweglichkeit liegt aber in der Regel weit unter 1 cm².V⁻¹.s⁻¹ (siehe dazu: J. Dresner in "Semiconductors and Semimetals", Vol. 21, Part C (1984), Seiten 193 ff.).

In der japanischen Offenlegungsschrift 59-26906 (vom 13.2.1984) ist ein amorphes Kohlenstoffmaterial beschrieben, welches - in Form von Dünnschichten - nach dem Plasma-CVD-Verfahren (CVD = Chemical Vapour Deposition) aus Kohlenwasserstoffen unter Einwirkung eines RF-Hochfrequenzfeldes hergestellt wird. Dieses Material weist Lumineszenz- und Halbleiterelgenschaften sowie eine hohe Härte auf. Der Lumineszenz-Peak liegt dabei bei 2,6 eV und der optische Bandabstand beträgt 3,0 eV (bei einem aus Propan bei einem Druck von 5.33 Pa (40 mTorr) hergestellten Material), bei einem vergleichsweise hohen elektrischen Widerstand von 10¹² oder 10¹³ Ω.cm.

Aus "IDR - Industrie Diamanten Rundschau", Bd. 18 (1984), Nr. 4, Seiten 249 ff. ist es andererseits bekannt, daß amorpher, wasserstoffhaltiger Kohlenstoff (a-C:H), der einen relativ hohen Wasserstoffgehalt von 13 bis 38 Atom-% aufweist, einen elektrischen Widerstand von 10¹³ Ω.cm und einen optischen Bandabstand von 0,8 bis 1,8 eV besitzt. Die a-C:H-Schichten werden dabei beispielsweise durch Plasmaabscheidung aus Benzoldampf bei Drücken von 1 bis 5 Pa mittels Hochfrequenzentladung hergestellt.

Aufgabe der Erfindung ist es, ein Halbleitergrundmaterial anzugeben, das in Dünnschichttechnologie unter Einsatz von Bandprozessen und ohne Hochtemperaturprozesse hergestellt werden kann, und das - in undotiertem Zustand - eine mit kristallinen Halbleitermaterialien, wie Si und GaAs, vergleichbare hohe Beweglichkeit der n- und p-Ladungsträger aufweist, wobei die Ladungsträgerbeweglichkeit bei Raumtemperatur wenigstens 1 cm².V⁻¹.s⁻¹ betragen soll.

Dies wird durch ein Halbleitergrundmaterial erreicht, das aus Dünnschichten aus amorphem, wasserstoffhaltigem Kohlenstoff (a-C:H) mit einem spezifischen elektrischen Widerstand zwischen 10¹ und 10⁸ Ω.cm und einer Ladungsträgerkonzentration (n + p) zwischen 10¹⁰ und 10¹⁸ cm⁻³, jeweils bei Raumtemperatur, besteht.

Halbleitende Dünnschichten mit einer n- und p-Ladungsträgerbeweglichkeit von über 1 cm².V⁻¹.s⁻¹, wie sie das erfindungsgemäß hergestellte Material aufweist, sind bislang bei amorphen Halbleitern im undotierten Zustand - nicht bekannt.

In einem halbleitenden Material liegt eine für viele Anwendungen bedeutsame hohe Beweglichkeit der beiden Ladungsträgerarten dann vor, wenn das Verhältnis der entsprechenden Hall-Konstanten zum spezifischen elektrischen Widerstand möglichst groß ist. Dies ist beim erfindungsgemäß hergestellten Halbleitergrundmaterial, d.h. speziellem a-C:H, der Fall. Bei diesem Material, bei dem deutlich weniger als 68 % der Kohlenstoffatome diamantgleiche tetraedrische Bindungen (sp³-Hybridisierung) und deutlich mehr als 30 % graphitische trigonale Bindungen (sp²-Hybridisierung) aufweisen und das einen Wasserstoffgehalt von 10 bis 30 Atom-% besitzt, wird die Forderung nach einer hohen Ladungsträgerbeweglichkeit über eine bestimmte Konzentration der n- und p-Ladungsträger und einen bestimmten spezifischen elektrischen Widerstand gezielt erfüllt, und zwar bis zu einem Optimum. Mit abnehmendem Zahlenwert des Produktes aus Ladungsträgerkonzentration und spezifischem elektrischen Widerstand ergibt sich ein wachsendes Verhältnis von Hall-Konstante zu spezifischem elektrischen Widerstand und damit eine steigende Beweglichkeit der Ladungsträger in der a-C:H-Schicht.

Vorteilhaft weist das erfindungsgemäß hergestellte Halbleitermaterial einen spezifischen elektrischen Widerstand etwa zwischen 10² und 5.10⁷ Ω.cm auf. Ein derartiges Material besitzt eine Beweglichkeit der n- und p-Ladungsträger von über 10² cm².V⁻¹.s⁻¹. Vorzugsweise liegt der spezifische elektrische Widerstand etwa zwischen 5.10³ und 5.10⁶ Ω.cm. Bei einem derartigen Material erreicht die n- und p-Ladungsträgerbeweglichkeit Werte über 10³ cm².V⁻¹.s⁻¹. Im übrigen weist das erfindungsgemäß hergestellte Halbleitermaterial einen optischen Bandabstand zwischen 1,4 und 2,4 eV auf.

Bei a-C:H-Schichten mit einem optischen Bandabstand < 1,4 eV und einem spezifischen elektrischen Widerstand < 10 Ω.cm ist die Beweglichkeit der Ladungsträger aufgrund einer niedrigen Hall-Konstante deutlich geringer, so daß derartige Materialien - im Sinne der vorliegenden Erfindung - nicht als Halbleitergrundmaterialien in Frage kommen. Andererseits wirkt bei a-C:H-Schichten mit einem spezifischen elektrischen Widerstand > 10⁸ Ω.cm der Widerstand einer Erhöhung der Hall-Beweglichkeit der Ladungsträger entgegen. Derartige a-C:H-Schichten sind bezüglich des elektrischen Widerstandes vergleichbar mit a-Si:H-Schichten, bei denen die Ladungsträgerbeweglichkeit unterhalb 1 cm².V⁻¹.s⁻¹ liegt.

Die Erfindung betrifft die Herstellung von amorphem, wasserstoffhaltigem Kohlenstoff, d.h. a-C:H, welcher eine Hall-Beweglichkeit der n-und p-Ladungsträger ≧ 1 cm².V⁻¹.s⁻¹ aufweist. Das a-C:H Halbleitergrundmaterial wird durch Hochfrequenz-Plasmaabscheidung gasförmiger Kohlenwasserstoffe bei einer mittleren Verweilzeit der Kohlenwasserstoffe im Plasma von mindestens 15 ms erhalten; die Verweilzeit ist dabei definiert als Quotient aus dem Produkt von Plasmavolumen und Gasdruck und dem Massedurchfluß.

Das Halbleitergrundmaterial, d.h. der amorphe, wasserstoffhaltige Kohlenstoff, wird durch Hochfrequenz-Plasmaabscheidung gasförmiger Kohlenwasserstoffe hergestellt. Dabei ist erfindungswesentlich, daß die mittlere Verweilzeit der Kohlenwasserstoffe im Plasma mindestens 15 ms beträgt. Die Verweilzeit t ist wie vorstehend definiert, d.h. t = p.V.mᵥ⁻¹; dabei ist p = Gasdruck (in Pa), V = Plasmavolumen (in cm³) und mᵥ = Massedurchfluß (in Pa.cm³.s⁻¹).

Halbleitende a-C:H-Schichten mit einer Ladungsträgerbeweglichkeit ≧ 1 cm².V⁻¹.s⁻¹ (im undotierten Zustand) sind, wie vorstehend bereits ausgeführt, bislang nicht bekannt. Entsprechend ist bislang auch kein Verfahren zur Herstellung derartiger Schichten bekannt, und es fehlen somit auch Hinweise auf relevante Prozeßparameter. Insbesondere findet sich im Stand der Technik kein Hinweis darauf, daß zur Erzielung einer bestimmten Hall-Beweglichkeit der Ladungsträger in a-C:H-Schichten das zur Plasmaabscheidung dienende Reaktionsgas, d.h. die Kohlenwasserstoffe, im Plasma eine ganz bestimmte Verweilzeit aufweisen muß, d.h. eine Verweilzeit von mindestens 15 ms. Bei einer Verweilzeit ≧ 15 ms werden nämlich Ladungsträgerbeweglichkeiten ≧ 1 cm².V⁻¹.s⁻¹ erreicht. Vorzugsweise beträgt die Verweilzeit der Kohlenwasserstoff-Moleküle in der Plasmazone zwischen 50 und 500 ms.

Eine Verweilzeit in der vorstehend genannten Größenordnung läßt sich - bei einem gegebenen Querschnitt des zur Plasmaabscheidung dienenden Reaktionsgefäßes - nur bei einem bestimmten Verhältnis zwischen Gasdruck, d.h. Partialdruck des Reaktionsgases, und Massedurchfluß erreichen. Beim erfindungsgemäßen Verfahren beträgt der Gasdruck deshalb vorteilhaft 5 bis 400 Pa, vorzugsweise 20 bis 200 Pa, und der Massedurchfluß vorteilhaft 0,05 bis 2.10⁵ Pa.cm³.s⁻¹. Ferner ist beim erfindungsgemäßen Verfahren wesentlich, daß das Substrat, auf dem a-C:H abgeschieden wird, nicht beheizt wird.

Zur Herstellung der halbleitenden a-C:H-Schichten nach der Erfindung mit einem - aufgrund hoher Ladungsträgerbeweglichkeiten - hohen Halbleitereigenschaftspotential dient ein Plasmaabscheideverfahren mit HF-Anregung (HF = Hochfrequenz) Vorzugsweise erfolgt die Plasmaabscheidung dabei mittels Radiofrequenz (RF), d.h. im Bereich zwischen 0,1 und 100 MHz, beispielsweise bei 13,46 MHz. Die Plasmaabscheidung kann aber auch mittels Mikrowellen (MW) erfolgen, d.h. im Bereich zwischen 0,1 und 1000 GHz, beispielsweise bei 2,45 GHz.

Als gasförmige Kohlenwasserstoffe dienen beim erfindungsgemäßen Verfahren vorzugsweise Alkane, d.h. gesättigte aliphatische Kohlenwasserstoffe, wie Methan, Ethan und Propan. Daneben können aber auch Alkene, d.h. ungesättigte aliphatische Kohlenwasserstoffe, wie Ethen und Propen, eingesetzt werden, sowie Acetylen, Cycloalkane, d.h. gesättigte cyclische Kohlenwasserstoffe, wie Cyclohexan, und - im dampfförmigen Zustand - aromatische Kohlenwasserstoffe in Form von Benzol und Benzolderivaten. Die Kohlenwasserstoffe der vorstehend genannten Art können einzeln oder im Gemisch zum Einsatz gelangen. Den Kohlenwasserstoffen können ferner Wasserstoff und/oder Edelgase, wie Helium und Argon, zugegeben werden.

In HF-Entladungen, insbesondere mit RF-Anregung, bildet sich bei unterschiedlich großen Innenelektroden der Entladungseinrichtung (Flächenverhältnis ≦ 0,5, vorzugsweise zwischen 0,25 und 0,05) - aufgrund von Raumladungen - eine im Takt der Hochfrequenz pulsierende Gleichstrom-Spannungskomponente (Vorspannung bzw. "self bias potential") bis zu etwa 1 kV aus. Diese DC-Spannungskomponente überlagert sich der HF-Wechselspannung und macht die kleinere Elektrode zur Kathode. Dadurch werden die geladenen CₓH_{y}-Teilchen, die durch Ionisierung und Fragmentierung des Reaktionsgases entstehen, zur Kathode hin beschleunigt und auf dem vor der Kathode angeordneten Substrat mit hoher kinetischer Energie - unter Bildung von a-C:H - abgeschieden. Ein "self bias"-Effekt der vorstehend genannten Art ist, wenngleich - wegen des Fehlens von Innenelektroden - in sehr viel geringerem Ausmaß, auch bei MW-induzierten Abscheideplasmen wirksam, weil zwischen Plasma und Substratfläche in jedem Fall eine Potentialdifferenz besteht.

In Plasmen zur a-C:H-Abscheidung bestimmt die Vorspannung im starken Maße die passiven physikalisch-chemischen Eigenschaften der gebildeten Schichten, wie Härte, Kratzfestigkeit und Brechzahl, jedoch weniger die Beweglichkeit der n- und p-Ladungsträger. Eine für viele Anwendungen anzustrebende Hall-Beweglichkeit der Ladungsträger über 1 cm¹.V⁻¹.s⁻¹ in undotiertem a-C:H wird vielmehr dann erreicht, wenn - entsprechend der Erfindung - das Verhältnis von Hall-Konstante zu spezifischem elektrischen Widerstand groß ist.

Die vorstehend genannte Bedingung kann durch eine bestimmte chemische Struktur der a-C:H-Schichten gezielt erfüllt werden, insbesondere durch ein bestimmtes Verhältnis von sp² - zu sp³-Bindungsanteilen der C-Atome unter Absättigung freier C-Valenzen ("dangling bonds") durch H-Atome. Die chemische Struktur der a-C:H-Schichten wiederum hängt von der relativen Konzentration der Spezies H, C₂ und CH im Plasma ab, die durch die Plasmabedingungen, insbesondere eingespeiste elektrische Leistung, Frequenz der HF-Anregung, Elektrodenform und -größe, Partialdruck des Reaktionsgases, Massedurchfluß und Beimengung von Inertgasen, beeinflußt und gesteuert werden kann. Zur Erzielung einer ausreichenden Konzentration an den Spezies H, C₂ und CH im Plasma wird diesem beim erfindungsgemäßen Verfahren deshalb eine elektrische Leistung zwischen 0,2 und 10 W.cm⁻³ zugeführt.

Anhand von Beispielen wird die Erfindung noch näher erläutert.

In eine Apparatur zur Plasmaabscheidung mittels Hochfrequenzentladung, d.h. in deren zylindrische Vakuumkammer aus Glas, wird Methan (CH₄) als Reaktionsgas eingeleitet. Das Reaktionsgas gelangt über einen engen Ringspalt in das sich zwischen zwei unterschiedlich großen planaren Elektroden ausbildende Plasmavolumen von ca. 45 cm³ (Flächenverhältnis der Elektroden: 1:4). Die beiden Elektroden, d.h. die Masseelektrode (Anode) und die HF-Elektrode (Kathode), sind mit einem RF-Generator (13,56 MHz) verbunden. Bei einer HF-Leistungsdichte von ca. 8 W.cm⁻³ im Plasmavolumen entsteht zwischen den beiden Elektroden eine Vorspannung von ca. 1 kV. Die kleinere der beiden Elektroden wird dabei Kathode, an der die a-C:H-Abscheidung erfolgt.

Unter den vorstehend genannten Bedingungen und bei unbeheiztem Substrat erhält man - bei einem Partialdruck des Reaktionsgases von 100 Pa und einem Massedurchfluß von 0,88.10⁵ Pa.cm³.s⁻¹ - bei einer Verweilzeit von 51 ms halbleitende a-C:H-Schichten mit einer Hall-Beweglichkeit der n-Ladungsträger über 10 cm².V⁻¹.s⁻¹.

In die zylindrische, aus Glas bestehende Vakuumkammer einer Apparatur zur Plasmaabscheidung wird - über eine zentrale Zuführung - Methan als Reaktionsgas eingeleitet. Die Kathode ist planar, während die Anode topfförmig ausgebildet ist; das Flächenverhältnis der Elektroden beträgt 1:6. Die a-C:H-Abscheidung erfolgt mittels Radiofrequenz (13,56 MHz) bei folgenden Bedingungen: Partialdruck des Reaktionsgases 20 Pa; Plasmavolumen: 400 cm³; Massedurchfluß: 0,32.10⁵ Pa.cm³.s⁻¹. Bei einer Verweilzeit von 250 ms und einer Leistungsdichte im Plasma von 0,8 W.cm⁻³ werden dabei - bei unbeheiztem Substrat - halbleitende a-C:H-Schichten mit einer Hall-Beweglichkeit der n-Ladungsträger von ca. 10³ cm².V⁻¹.s⁻¹ erhalten.

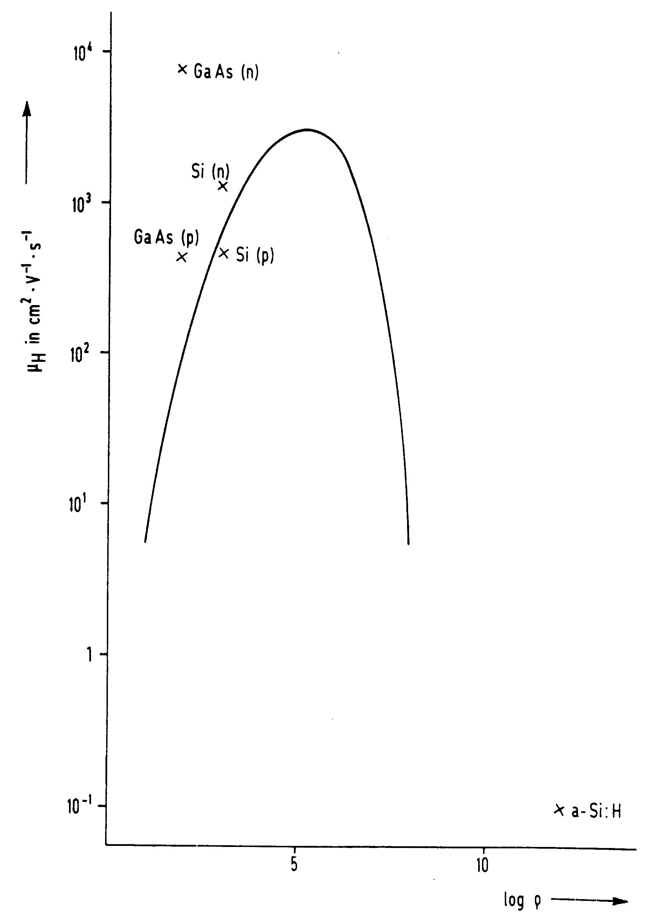

In Figur 1 ist die Hall-Beweglichkeit µ_{H} der n- und p-Ladungstrager der erfindungsgemäß hergestellten a-C:H-Schichten als Funktion des spezifischen elektrischen Widerstandes ρ dargestellt. Daneben sind auch die Werte für kristallines Si und GaAs sowie für a-Si:H wiedergegeben.

## Patentansprüche

1. Verfahren zur Herstellung eines Halbleitergrundmaterials aus Dünnschichten aus amorphem, wasserstoffhaltigem Kohlenstoff (a-C:H), durch Hochfrequenz-Plasmaabscheidung gasförmiger Kohlenwasserstoffe auf einem Substrat **dadurch gekennzeichnet,** daß
- die mittlere Verweilzeit der Kohlenwasserstoffe im Plasma mindestens 15 ms beträgt, wobei die Verweilzeit definiert ist als Quotient aus dem Produkt von Plasmavolumen und Gasdruck und dem Massedurchfluß,
- die Leistungsdichte im Plasma zwischen 0,2 und 10 W.cm⁻³ beträgt, und
- das Substrat nicht beheizt wird.

2. Verfahren nach Anspruch 1, **dadurch gekennzeichnet,** daß die mittlere Verweilzeit zwischen 50 und 500 ms beträgt.

3. Verfahren nach Anspruch 1 oder 2, **dadurch gekennzeichnet,** daß der Gasdruck 5 bis 400 Pa, vorzugsweise 20 bis 200 Pa, beträgt.

4. Verfahren nach einem der Ansprüche 1 bis 3, **dadurch gekennzeichnet,** daß der Massedurchfluß 0,05.10⁵ bis 2.10⁵ Pa.cm³.s⁻¹ beträgt.

5. Verfahren nach einem oder mehreren der Ansprüche 1 bis 4, **dadurch gekennzeichnet,** daß die Plasmaabscheidung mittels Radiofrequenz erfolgt.

6. Verfahren nach einem oder mehreren der Ansprüche 1 bis 5, **dadurch gekennzeichnet,** daß als Kohlenwasserstoffe Alkane eingesetzt werden.

## Claims

1. Method for producing a semiconductor base material, consisting of thin layers of amorphous hydrogen-containing carbon (a-C:H), by means of high-frequency plasma deposition of gaseous hydrocarbons on a substrate, characterised in that
- the average dwell time of the hydrocarbons in the plasma amounts to at least 15 ms, wherein the dwell time is defined as the quotient of the product of plasma volume and gas pressure and the mass through-flow,
- the power density in the plasma amounts to between 0.2 and 10 W.cm⁻³, and
- the substrate is not heated.

2. Method according to claim 1, characterised in that the average dwell time amounts to between 50 and 500 ms.

3. Method according to claim 1 or 2, characterised in that the gas pressure amounts to between 5 and 400 Pa, preferably between 20 and 200 Pa.

4. Method according to one of the claims 1 to 3, characterised in that the mass through-flow amounts to between 0.05x10⁵ and 2x10⁵ Pa.cm³.s⁻¹.

5. Method according to one or several of the claims 1 to 4, characterised in that the plasma deposition is effected by means of radio frequency.

6. Method according to one or several of the claims 1 to 5, characterised in that alkanes are used as hydrocarbons.

## Revendications

1. Procédé de fabrication d'un matériau de base à semiconducteurs constitué de couches minces de carbone hydrogéné amorphe (a-C:H), par précipitation en plasma à haute fréquence de carbures d'hydrogène sous forme gazeuse, sur un substrat, caractérisé en ce que,
- la durée moyenne de séjour des carbures d'hydrogène dans le plasma est au moins de 15 ms, la durée de séjour étant définie comme étant le quotient du produit du volume de plasma et de la pression gazeuse, par le débit massique,
- la puissance volumique dans le plasma est située entre 0,2 et 10 W.cm⁻³ et
- le substrat n'est pas chauffé.

2. Procédé suivant la revendication 1, caractérisé en ce que la durée moyenne de séjour est située entre 50 et 500 ms.

3. Procédé suivant la revendication 1 ou 2, caractérisé en ce que la pression gazeuse est de 5 à 400 Pa, de préférence de 20 à 200 Pa.

4. Procédé suivant l'une des revendications 1 à 3, caractérisé en ce que le débit massique est de 0,05.10⁵ à 2.10⁵ Pa.cm³.s⁻¹.

5. Procédé suivant l'une quelconque des revendications 1 à 4, caractérisé en ce que la précipitation en plasma s'effectue au moyen de radiofréquence.

6. Procédé suivant l'une quelconque des revendications 1 à 5, caractérisé en ce qu'on utilise des alcanes, en tant que carbures d'hydrogène.
